(19) Europäisches Patentamt / European Patent Office / Office européen des brevets

(11) **EP 2 651 033 B1**

(12) **EUROPEAN PATENT SPECIFICATION**

(45) Date of publication and mention of the grant of the patent:
**17.06.2020  Bulletin 2020/25**

(51) Int Cl.:
***H03H 17/04*** *(2006.01)*

(21) Application number: **12163968.6**

(22) Date of filing: **12.04.2012**

(54) **Filter system**

Filtersystem

Système filtrant

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**16.10.2013  Bulletin 2013/42**

(73) Proprietor: **Siemens Aktiengesellschaft**
**80333 München (DE)**

(72) Inventors:
- **Bako, Dr. Tamas**
  **1132 Budapest (HU)**
- **Borger, Thomas**
  **64846 Klein-Zimmern (DE)**
- **Ladanyi, Gergo**
  **3524 Miskolc (HU)**
- **Szigethy, Tamas**
  **1165 Budapest (HU)**

(56) References cited:
**US-B1- 7 098 731**

- **ANONYMOUS: "Lecture 20: 2.161 Signal Processing: Continuous and Discrete", MIT OpenCourseWare , 2008, pages 20-1-20-14, XP002684483, Retrieved from the Internet: URL:http://ocw.mit.edu/courses/mechanical-engineering/2-161-signal-processing-continuous-and-discrete-fall-2008/lecture-notes/lecture_20.pdf [retrieved on 2012-10-19]**

- **MASKELL D L ET AL: "Analysis of even order IIR digital filters implemented as a cascade of first order complex allpass sections", ISCAS, 7 June 1988 (1988-06-07), pages 531-534, XP010069605,**
- **R. Jamal et al.: "Filters" In: "Electrical Measurement, Signal Processing, and Displays", 2004, CRC Press LLC, XP002684485, ISBN: 978-0-203-00940-6 pages 22-1-22-28, * pages 22-23, last paragraph; figure 22.13 ***
- **D. Schlichthärle: "Digital Filters", 2011, Springer-Verlag, Berlin, XP002684484, ISBN: 978-3-642-14325-0 pages 420-437, * page 421, line 1 - page 422, line 15 ***
- **J. Goette: "Ftal Mse: Hardware Algorithms On Fixed-Point Filter Realizations", MSE , 10 October 2011 (2011-10-10), pages 1-103, XP002684486, Retrieved from the Internet: URL:http://www.google.nl/url?sa=t&rct=j&q= &esrc=s&source=web&cd=1&ved=0CCQQFjAA &url= http%3A%2F%2Fwww.microlab.ti.bfh.ch%2Fma st er%2Fmse%2Femhwdes%2Fpublic%2Femhwde s%2Far ticle_fixed_A5.pdf&ei=jANrUIidOMnAtAb0_oAY &usg=AFQjCNFwOH4PYbH2rrpDvJLBg1ek6duT Xw&si g2=0R3eBYq7Ll5-SHK3_to6rw [retrieved on 2012-10-01]**

**Description**

The invention concerns a filter system with infinite impulse response.

Infinite impulse response (IIR) filters are popular in digital signal processing. They are characterized by an impulse response function that is non-zero over an infinite length of time. IIR filters can be defined through a transfer function that is a mathematical representation in terms of spatial or temporal frequency, of the relation between the input and output signal of the filter.

In the case of a digital filter, the transfer function can be expressed in the z-domain as:

$$H(z) = K_{tot} \cdot \frac{b_0 + b_1 z^{-1} + \ldots + b_N z^N}{a_0 + a_1 z^{-1} + \ldots + a_M z^{-M}},$$

where *a* and *b* are the coefficients of the polynomials in the numerator and denominator, and *K* is the overall gain. (In the case of the direct realization, *a* and *b* are the coefficients of the created filter as well.) The technical realization of an IIR filter with a given transfer function is straightforward and can be done by means of well-known evaluations of the transfer function such as e.g. Direct Form I or Direct Form II.

Compared to finite impulse response (FIR) filters, IIR filters feature a small memory consumption and small calculational demand. One disadvantage of them is that - due to sensitivity for quantization and calculation errors - in certain cases the output of an IIR filter can become noisy, inaccurate or the filter can become unstable.

The problem that the present invention wants to solve is therefore creating a filter system that has a particularly low sensitivity in the numerical representation of filter coefficients.

This problem is inventively solved by a filter system, wherein the transfer function of the filter system comprises at least one pair of first order polynomial fractions.

The invention is based on the consideration that high order polynomials are sensitive to the representation accuracy of their coefficients. Small inaccuracies in the coefficients lead to large changes in the roots of the polynomials, hence the shape of the polynomial and the filter characteristic itself will strongly change.

The sensitivity of the polynomial at a given point for small perturbations in the coefficient can be characterized by the derivative of the polynomial (more information can be read about this e.g. in P. Guillaume, J. Schoukens and R. Pin-telon, "Sensitivity of Roots to Errors in the Coefficient of Polynomials Obtained by Frequency-Domain Estimation Methods," IEEE Trans. on Instr. and Meas. vol. 38, pp. 1050-1056 , Dec. 1989.). If the derivative is small, the polynomial is very sensitive at that point. If the polynomial is expressed as

$$p(z) = \prod_{i=1}^{N} (z^{-1} - r_i) = b_0 + \ldots + b_N z^{-N},$$

then the derivative is

$$\frac{dp(z)}{dz} = \frac{\prod_{i=1}^{N} (z^{-1} - r_i)}{(z^{-1} - r_1)} + \ldots + \frac{\prod_{i=1}^{N} (z^{-1} - r_i)}{(z^{-1} - r_N)},$$

where r is one root of the polynomial (if it belongs to the numerator, it will be the zero of the filter, if it belongs to the denominator it is the pole of the filter). This formula can be very small - hence the shape of the polynomial can be sensitive - if the roots are close together and the polynomial order is high. This is typical at high filter orders and when the filter corner frequency is low or the filter bandwidth is small (compared to the sampling frequency).

ANONYMOUS: "Lecture 20: 2.161 Signal Processing: Continuous and Discrete", MIT OpenCourseWare, , 2008, pages 20-1-20-14, discloses a cascade structure of complex conjugate pole and zero pairs and first-order sections.

MASKELL D L ET AL: "Analysis of even order IIR digital filters implemented as a cascade of first order complex allpass sections", ISCAS, 7 June 1988 (1988-06-07), pages 531-534, discloses a cascadable first order complex allpass sections.

D. Schlichthärle: "Digital Filters", 2011, Springer-Verlag, Berlin, pages 420-437, discloses a transfer function defining a cascade arrangement of second-order filter blocks.

J. Goette: "Ftal Mse: Hardware Algorithms On Fixed-Point Filter Realizations", MSE, 10 October 2011 (2011-10-10), pages 1-103, discloses a cascaded structure comprising pairs of complex-conjugate poles realized separately.

US7098731 B1 discloses an active complex bandpass filter comprising cascaded first-order low pass sections.

Inaccuracy of coefficients happens since the numerical representation of them has finite length. E.g. the IEEE 754 single precision floating-point format is only 7 digits accurate. Theoretically, the accuracy of the coefficients can be increased e.g. by using IEEE 754 double precision or quadruple precision. However, today's digital signal processors support only single precision calculations.

The following list shows some examples for the inaccuracy:

- A $10^{th}$ order Butterworth low-pass or high-pass filter, with IEEE 754 double precision calculations, becomes extremely inaccurate (more than 0.5 dB inaccuracy in the pass-band), if the corner frequency is lower than the 1/50-th part of the sampling frequency.
- A $10^{th}$ order Butterworth low-pass or high-pass filter, with IEEE 754 single precision calculations, becomes extremely inaccurate (more than 0.5 dB inaccuracy in the pass-band), if the corner frequency is lower than the 1/10-th part of the sampling frequency.
- A $2^{nd}$ order Butterworth low-pass or high-pass filter, with IEEE 754 single precision calculations becomes extremely inaccurate (more than 0.5 dB inaccuracy in the pass-band), if the corner frequency is lower than 1/1000-th part of the sampling frequency.

Splitting the original filter transfer function to the multiplicatives of smaller polynomial fractions efficiently decreases the sensitivity of the characteristic to numerical inaccuracies. One solution is to split the original transfer function into second order sections because calculations there will not be too difficult (cascaded biquad filters).

However, as the last example above shows, sometimes this is not enough.

A better realization than traditional second order sections which has the smallest sensitivity for numerical inaccuracies in coefficients can be achieved by using cascaded first order polynomial fractions:

$$H_1(z) = K_1 \cdot \frac{z^{-1} - c}{z^{-1} - d} = K_1 \cdot \frac{z^{-1} - (\gamma + j\delta)}{z^{-1} - (\alpha + j\beta)},$$

where j is the imaginary unit, i.e. the square root of -1. The derivative of a first order polynomial is always around 1. Hence the filter constructed from these first order polynomial fractions will become very stable.

Generally, this requires many calculations with complex numbers. The overall filter structure can be further simplified by arranging the polynomial roots into complex conjugate pairs, i.e. advantageously the poles and/or the zeros of the pair of polynomial fractions are complex conjugates, respectively:

$$H_2(z) = K_2 \cdot \frac{z^{-1} - (\gamma + j\delta)}{z^{-1} - (\alpha + j\beta)} \cdot \frac{z^{-1} - (\gamma - j\delta)}{z^{-1} - (\alpha - j\beta)},$$

wherein $\alpha$, $\beta$, $\gamma$, $\delta$ are real numbers. In this case - for real input signals, of course - a second order block always has real input and real output that simplifies calculations. This forms a new second order filter structure.

Furthermore, the gain of the transfer function is advantageously realized by virtue of at least two separate multiplier elements, i.e. a split gain. This realization makes sense at fixed point realization. In this case the value range of internal variables will be the same (this is not required when using floating point calculations). E.g. in the case of structures for floating point realization, transients can be minimized by multiplying the internal variable at the first delay by the square root of gain change, and multiplying the internal variables at the second and third delays by the gain change.

The structure further simplifies, if the value of zeros of the pair of polynomial fractions is advantageously -1 or 1. Here, multiplier elements for the numerator of the polynomial fractions can be eliminated. This happens in the case of low-pass or high-pass Butterworth filter realizations.

In a further advantageous embodiment, the transfer function of the filter systems consists of cascaded pairs of first order polynomial fractions and at most one single first order polynomial fraction, wherein the poles and the zeros of each pair of polynomial fractions are complex conjugates, respectively. This provides a particularly advantageous way of creating higher order filter structures with the proposed filter structure by cascading the second order filter structures. Odd order filter structures can be created by cascading a first order filter to the cascaded second order structures.

The invention is defined by the filter system of the independent claims.

The advantages achieved by the invention comprise particularly the creation of a new, second order IIR filter structure that is stable and has high accuracy on extreme low frequencies as well. The original filter transfer function is split into first order fraction parts. These fraction parts are complex conjugates. The new filter structure is created by realizing these parts assuming real (not complex) input and output signals. The coefficients of the filter are simply the real and imaginary part of the poles and zeros. The proposed new filter structure has extremely small output transients at filter coefficient change.

Embodiments of the invention are explained in more detail in the following figures.

FIG 1 shows a realization of a first order filter with one complex pole and one complex zero,

FIG 2 shows a realization of the proposed filter structure with complex conjugate pole and zero pairs for real input and according to the invention,

FIG 3 shows another realization with the *K* over-all gain split in three pieces according to the invention,

FIG 4 shows a second order high-pass Butterworth filter realization with the proposed filter structure,

FIG 5 shows a second order low-pass Butterworth filter realization with the proposed filter structure,

FIG 6 shows a modified Butterworth filter structure for fixed point implementation with split gain,

FIG 7 shows a graph of the characteristics of the proposed filter structure and a usual Direct Form I structure,

FIG 8 shows a graph of the total harmonic distortion plus noise (THD+N) of the proposed filter structure and a usual Direct Form I structure at several corner frequencies,

FIG 9 shows a graph of the corner frequency switching transients of a second order low-pass Butterworth filter, realized with the proposed filter structure, in the case of a DC input signal (sampling freq is 48 kHz), and

FIG 10 Corner frequency switching transients of a $2^{nd}$ order LP Butterworth filter, realized with the new filter structure, in the case of 5 Hz sinusoid input signal (sampling freq is 48 kHz).

Equal parts have the same reference numerals in all FIGs.

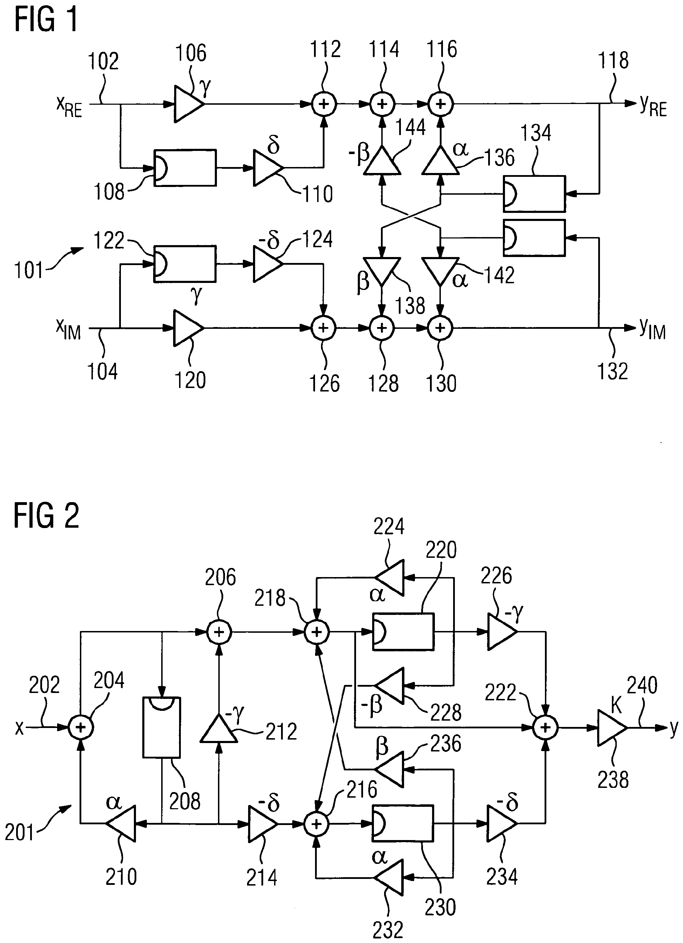

FIG 1 shows a straightforward realization of a first order filter with one complex pole and one complex zero with the transfer function:

$$H_1(z) = K_1 \cdot \frac{z^{-1} - c}{z^{-1} - d} = K_1 \cdot \frac{z^{-1} - (\gamma + j\delta)}{z^{-1} - (\alpha + j\beta)}.$$

The block diagram according to FIG 1 shows a filter system 101 with split real input 102 and imaginary input 104. The real input 102 is fed in parallel into a multiplier 106 with value $\gamma$ and a delay 108 with serially connected multiplier 110 with value $\delta$. The signal from multipliers 106 and 110 are fed into adder 112 and from there serially into adders 114 and 116, the latter's signal then forming the real output 118 of the filter.

Equally, the imaginary input 104 is fed in parallel into a multiplier 120 with value $\gamma$ and a delay 122 with serially connected multiplier 124 with value $-\delta$. The signal from multipliers 120 and 124 are fed into adder 126 and from there serially into adders 128 and 130, the latter's signal then forming the imaginary output 132 of the filter.

The real 118 output is fed into a further delay 134 and from there split into multiplier 136 with value $\alpha$ leading to adder 116 and multiplier 138 with value $\beta$ leading to adder 128. Equally, the imaginary output 132 is fed into a further delay 140 and from there split into multiplier 142 with value $\alpha$ leading to adder 130 and multiplier 144 with value $-\beta$ leading to adder 114.

FIG 2 shows a possible realization of the proposed filter structure with complex conjugate pole and zero pairs for real input and output based on the transfer function:

$$H_2(z) = K_2 \cdot \frac{z^{-1} - (\gamma + j\delta)}{z^{-1} - (\alpha + j\beta)} \cdot \frac{z^{-1} - (\gamma - j\delta)}{z^{-1} - (\alpha - j\beta)}.$$

The block diagram according to FIG 2 shows a filter system 201 with real input 202, fed into adder 204. Adder 204's output is split into adder 206 and delay 208. The output of delay 208 is split into multiplier 210 with value $\alpha$ leading to adder 204, multiplier 212 with value $-\gamma$ leading to adder 206 and multiplier 214 with value $-\delta$ leading to adder 216.

Adder 206's output is fed into adder 218 and further split into delay 220 and adder 222. The output signal of delay 220 is split into multiplier 224 with value $\alpha$ leading to adder 218, multiplier 226 with value $-\gamma$ leading to adder 222 and multiplier 228 with value $-\beta$ leading to adder 216. Adder 216's output is fed into delay 230. The output signal of delay 230 is split into multiplier 232 with value $\alpha$ leading to adder 216, multiplier 234 with value $-\delta$ leading to adder 222 and multiplier 236 with value $\beta$ leading to adder 218. The output of adder 222 is fed into multiplier 238 with value $K$ (the gain of filter system 201) whose output forms the real output 240 of the filter system 201.

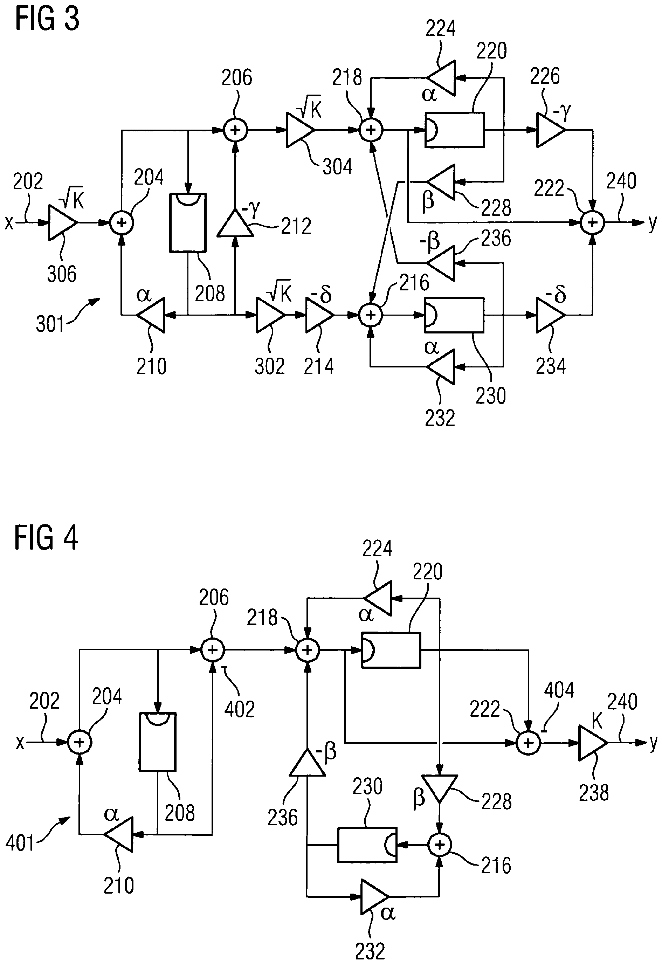

FIG 3 shows another possible realization of the filter structure according to FIG 2 with split gain. The block diagram of filter system 301 according to FIG 3 is similar to that of FIG 2 and is merely explained regarding the differences to FIG 2.

In filter system 301, multiplier 238 of FIG 2 is removed and replaced by multiplier 302 with value sqrt($K$) immediately before multiplier 214, multiplier 304 with value sqrt($K$) immediately before adder 218 and multiplier 306 with value sqrt ($K$) right before adder 204. As described above, this realization makes sense at fixed point realization. In this case the value range of internal variables will be the same (this is not required at floating point calculations). The structure further simplifies, if the value of zeros are -1 or 1, i.e. $\delta = \gamma = 0$. This happens in the case of low-pass or high-pass Butterworth filter realizations.

The block diagram according to FIG 4 shows a second order high-pass Butterworth filter system 401 with the proposed filter structure. FIG 4 equals to FIG 2 with $\delta = 0$, i.e. multipliers 214 and 234 and their signal paths removed and $\gamma = 1$, i.e. multipliers 212 and 226 replaced by simple negations 402 and 404.

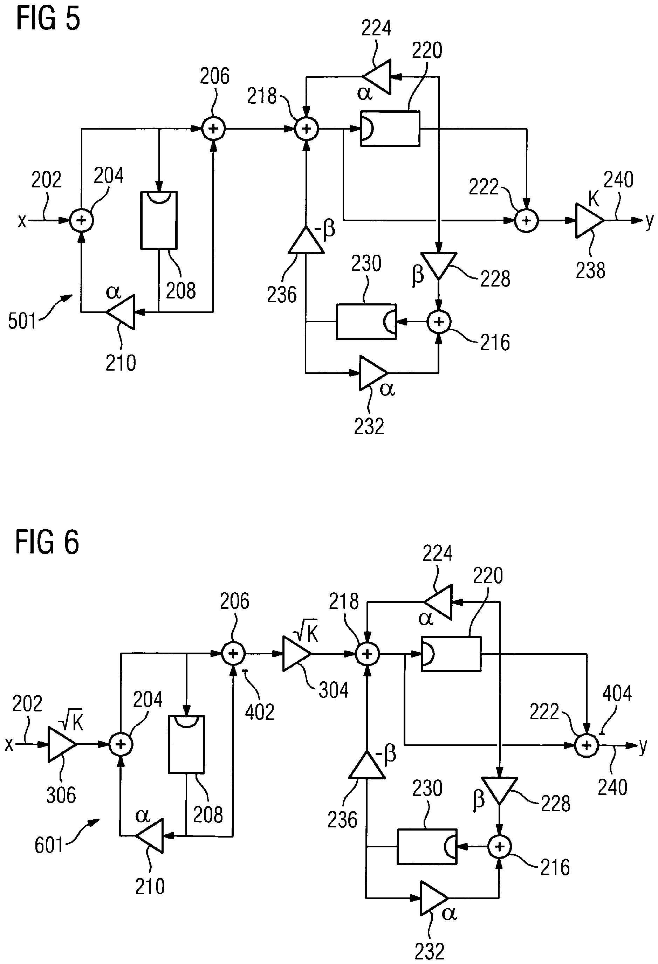

The block diagram according to FIG 5 shows a second order low-pass Butterworth filter system 501 with the proposed filter structure. FIG 5 equals to FIG 4 with the negations 402, 404 removed because $\gamma = -1$.

The block diagram according to FIG 6 shows a modified high-pass Butterworth filter system 601 for fixed point implementation with split gain. FIG 6 equals to FIG 3 with $\delta = 0$, i.e. multipliers 214 and 234 and their signal paths removed and $\gamma = 1$, i.e. multipliers 212 and 226 replaced by simple negations 402 and 404.

The shown filter structures 201, 301, 401, 501, 601 provide a particularly advantageous way of creating higher order filter structures by cascading the second order filter structures 201, 301, 401, 501, 601 in arbitrary selection and number. Odd order filter structures can be created by cascading a first order filter to the cascaded second order filter systems 201, 301, 401, 501, 601.

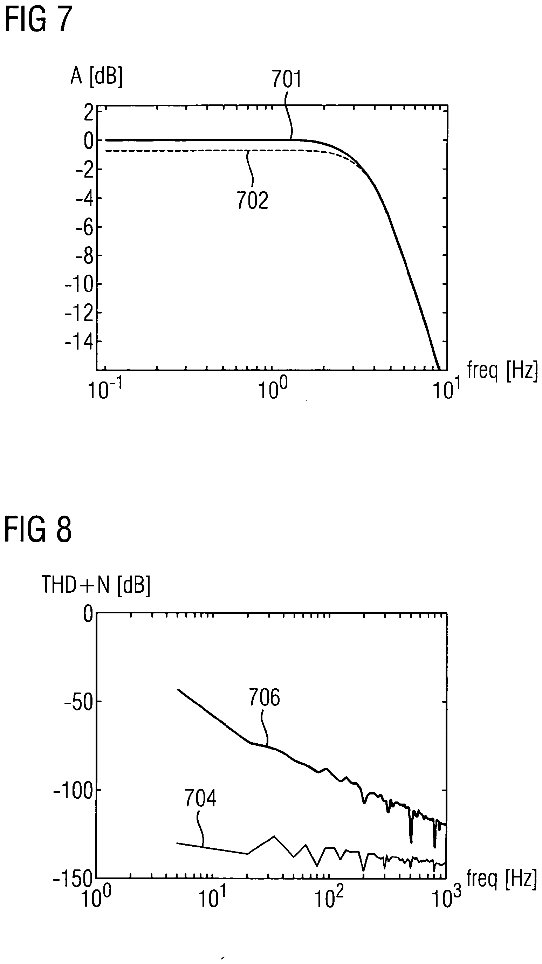

The new filter structure has much better accuracy on low corner frequencies, or when the filter bandwidth is small. Comparison of characteristics of the traditional, direct form I filter and the proposed filter structure - by using only single precision calculations - can be seen in FIG 7. The noise behavior can be seen in FIG 8. Here, a Direct Form I structure is used for comparison, because it is more stable than Direct Form II.

FIG 7 shows the characteristics in a graph with the amplitude change A in unit dB plotted against the frequency *freq* in unit Hz. Line 701 shows the proposed filter structure and line 702 the Direct Form I structure. The realized characteristic is a second order Butterworth low-pass filter, the corner frequency is at 4 Hz, the sampling frequency is at 48 kHz.

The graph according to FIG 8 shows the *THD+N* in unit dB of the proposed filter structure (line 704) and Direct Form I structure (line 706) plotted against the corner frequencies *freq* in unit Hz. The realized characteristic is a second order Butterworth low-pass filter with sampling frequency 48 kHz.

The proposed filter structure has a very good transient behavior as well. Traditional filter structures (e.g. Direct Form II or Lattice) can make strong transients when the corner frequency of the filter is changed during filtering. In the case of the proposed filter structure made for fixed point realization (split gain), transients are very small at coefficient changes.

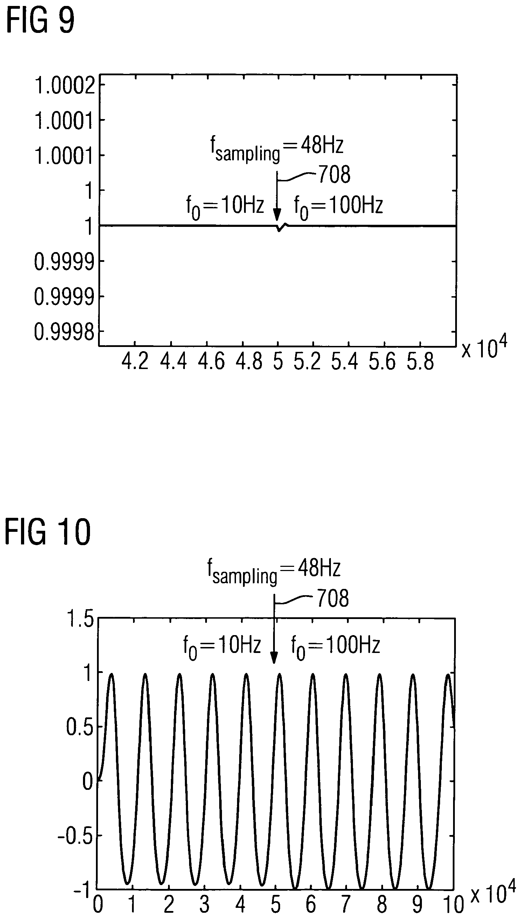

In FIGs 9 and 10 the filter transients, i.e. the output signals can be seen, when a second order low pass Butterworth filter according to the proposed filter structure is switched from 10 Hz corner frequency to 100 Hz corner frequency. The input in FIG 9 is a DC signal, in FIG 10 it is a 5 Hz sinusoid. The signals are plotted against time, the change of corner frequency happens at arrow 708 and the sampling frequency in both cases is 48 kHz. The transient caused by the one decade change in corner frequency is negligibly small.

List of reference numerals

| | |
|---|---|
| 101 | filter system |
| 102 | real input |
| 104 | imaginary input |
| 106 | multiplier |
| 108 | delay |
| 110 | multiplier |
| 112, 114, 116 | adder |
| 118 | real output |
| 104 | imaginary input |
| 120 | multiplier |
| 122 | delay |
| 124 | multiplier |
| 126, 128, 130 | adder |
| 132 | imaginary output |
| 134 | delay |
| 136, 138 | multiplier |
| 140 | delay |
| 142, 144 | multiplier |
| 201 | filter system |
| 202 | real input |
| 204, 206 | adder |
| 208 | delay |
| 210, 212, 214 | multiplier |
| 216, 218 | adder |
| 220 | delay |
| 222 | adder |
| 224, 226, 228 | multiplier |
| 230 | delay |
| 232, 234, 236, 238 | multiplier |
| 240 | real output |
| 301 | filter system |
| 302, 304, 306 | multiplier |
| 401 | filter system |
| 402, 404 | negation |
| 501, 601 | filter system |
| 701, 702, 704, 706 | line |
| 708 | arrow |

**Claims**

1. A filter system (201) having an infinite impulse response having real input and output, wherein the transfer function of the filter system includes at least one pair of poles and/or zeros respectively complex conjugates, and

    - wherein the real input (202) is fed to a first adder (204),
    - an output of the first adder (204) is split and connected to a second adder (206) and a first delay (208), and
    - an output of the first delay (208) is split and connected to a first multiplier (210) having a first coefficient, the output of which is connected to the first adder (204), to a second multiplier (212) having a second coefficient, the output of which is connected to the second adder (206), and to a third multiplier (214) having a third coefficient, the output of which is connected to a third adder (216), and
    - an output of the second adder (206) is fed to a fourth adder (218), and
    - an output of the fourth adder (218) is split and connected to a second delay (220) and a fifth adder (222), and
    - an output of the second delay (220) is split and connected to a fourth multiplier (224) having the first coefficient, the output of which is connected to the fourth adder (218), to a fifth multiplier (226) having the second coefficient, the output of which is connected to the fifth adder (222) and to a sixth multiplier (228) having a fourth coefficient, the output of which is connected to the third adder (216), and
- an output of the third adder (216) is fed to a third delay (230), and
- an output of the third delay (230) is split and connected to a seventh multiplier (232) having the first coefficient, the output of which is connected to the third adder (216), to an eighth multiplier (234) having the third coefficient, the output of which is connected to the fifth adder (222), and to a ninth multiplier (236) having a fifth coefficient, the output of which is connected to the fourth adder (218), and
- the fourth coefficient and the fifth coefficient being equal with opposite sign to each other, and
- an output of the fifth adder (222) is fed to a tenth multiplier (238) having a gain (K, $K_2$), the output of the tenth multiplier forming the real output (240) of the filter system (201).

2. A filter system (201) having an infinite impulse response having real input and output, wherein the transfer function of the filter system includes at least one pair of poles and/or zeros respectively complex conjugates, and

- wherein the real input (202) is fed to a first adder (204),
- an output of the first adder (204) is split and connected to a second adder (206) and a first delay (208), and
- an output of the first delay (208) is split and connected to a first multiplier (210) having a first coefficient, the output of which is connected to the first adder (204), to a second multiplier (212) having a second coefficient, the output of which is connected to the second adder (206), and to a third multiplier (214) having a third coefficient being connected to a third adder (216),and
- an output of the second adder (206) is fed to a fourth adder (218), and
- an output of the fourth adder (218) is split and connected to a second delay (220) and a fifth adder (222), and
- an output of the second delay (220) is split and connected to a fourth multiplier (224) having the first coefficient, the output of which is connected to the fourth adder (218), to a fifth multiplier (226) having the second coefficient, the output of which is connected to the fifth adder (222) and to a sixth multiplier (228) having a fourth coefficient, the output of which is connected to the third adder (216), and
- an output of the third adder (216) is fed to a third delay (230), and
- an output of the third delay (230) is split and connected to a seventh multiplier (232) having the first coefficient, the output of which is connected to the third adder (216), to an eighth multiplier (234) having the third coefficient, the output of which is connected to the fifth adder (222), and to a ninth multiplier (236) having a fifth coefficient, the output of which is connected to the fourth adder (218), and
- the fourth coefficient and the fifth coefficient being equal with opposite sign to each other, and
- a gain implemented by means of three separate multiplier elements (302, 304, 306) having a square root value of said gain, the separate multiplier elements being respectively placed before the third multiplier (214), before the fourth adder (218), and before the first adder (204), the output of the fifth adder forming the real output (240) of the filter system (201).

3. A filter system comprising a cascade of filters according to claim 1 or 2.

4. A filter system of an odd order comprising a cascade of a first-order filter and a filter system according to claim 1 or 2.

5. The filter system of claim 1 wherein the transfer function of the filter system is as follows:

$$H_2(z) = K_2 \cdot \frac{z^{-1} - (\gamma + j\delta)}{z^{-1} - (\alpha + j\beta)} \cdot \frac{z^{-1} - (\gamma - j\delta)}{z^{-1} - (\alpha - j\beta)}$$

where K2 is the gain, $\gamma$ is equal to the second coefficient with opposite sign, $\delta$ is equal to the third coefficient with opposite sign, $\alpha$ is the first coefficient, and $\beta$ is the fifth coefficient.

6. The filter system of claim 5, wherein the values of the zeros of the transfer function of the filter system are 1 or -1, so that $\delta = \gamma = 0$.

7. An electronic device comprising a filter system according to any of the preceding claims.

**Patentansprüche**

1. Filtersystem (201) mit einer unendlichen Impulsantwort mit realem Eingang und Ausgang, wobei die Übertragungsfunktion des Filtersystems wenigstens ein Paar Polstellen und/oder Nullstellen bzw. Komplex-Konjugierte enthält und

   - wobei der reale Eingang (202) einem ersten Addierer (204) zugeführt ist,
   - ein Ausgang des ersten Addierers (204) geteilt und mit einem zweiten Addierer (206) und einem ersten Verzögerungsglied (208) verbunden ist und
   - ein Ausgang des ersten Verzögerungsglieds (208) geteilt und mit einem ersten Multiplizierer (210), der einen ersten Koeffizienten aufweist, verbunden ist, dessen Ausgang verbunden ist mit dem ersten Addierer (204), mit einem zweiten Multiplizierer (212), der einen zweiten Koeffizienten aufweist, dessen Ausgang mit dem zweiten Addierer (206) verbunden ist, und mit einem dritten Multiplizierer (214), der einen dritten Koeffizienten aufweist, dessen Ausgang mit einem dritten Addierer (216) verbunden ist, und
   - ein Ausgang des zweiten Addierers (206) einem vierten Addierer (218) zugeführt ist und
   - ein Ausgang des vierten Addierers (218) geteilt und mit einem zweiten Verzögerungsglied (220) und einem fünften Addierer (222) verbunden ist und
   - ein Ausgang des zweiten Verzögerungsglieds (220) geteilt und mit einem vierten Multiplizierer (224), der den ersten Koeffizienten aufweist, verbunden ist, dessen Ausgang verbunden ist mit dem vierten Addierer (218), mit einem fünften Multiplizierer (226), der den zweiten Koeffizienten aufweist, dessen Ausgang mit dem fünften Addierer (222) verbunden ist, und mit einem sechsten Multiplizierer (228), der einen vierten Koeffizienten aufweist, dessen Ausgang mit dem dritten Addierer (216) verbunden ist, und
   - ein Ausgang des dritten Addierers (216) einem dritten Verzögerungsglied (230) zugeführt ist,
   - ein Ausgang des dritten Verzögerungsglieds (230) geteilt und mit einem siebten Multiplizierer (232), der den ersten Koeffizienten aufweist, verbunden ist, dessen Ausgang verbunden ist mit dem dritten Addierer (216), mit einem achten Multiplizierer (234), der den dritten Koeffizienten aufweist, dessen Ausgang mit dem fünften Addierer (222) verbunden ist, und mit einem neunten Multiplizierer (236), der einen fünften Koeffizienten aufweist, dessen Ausgang mit dem vierten Addierer (218) verbunden ist, und
   - der vierte Koeffizient und der fünfte Koeffizient mit entgegengesetztem Vorzeichen einander gleich sind und
   - ein Ausgang des fünften Addierers (222) einem zehnten Multiplizierer (238) zugeführt ist, der eine Verstärkung $(K, K_2)$ aufweist, wobei der Ausgang des zehnten Multiplizierers den realen Ausgang (240) des Filtersystems (201) bildet.

2. Filtersystem (201) mit einer unendlichen Impulsantwort mit realem Eingang und Ausgang, wobei die Übertragungsfunktion des Filtersystems wenigstens ein Paar Polstellen und/oder Nullstellen bzw. Komplex-Konjugierte enthält und

   - wobei der reale Eingang (202) einem ersten Addierer (204) zugeführt ist,
   - ein Ausgang des ersten Addierers (204) geteilt und mit einem zweiten Addierer (206) und einem ersten Verzögerungsglied (208) verbunden ist und
   - ein Ausgang des ersten Verzögerungsglieds (208) geteilt und mit einem ersten Multiplizierer (210), der einen ersten Koeffizienten aufweist, verbunden ist, dessen Ausgang verbunden ist mit dem ersten Addierer (204), mit einem zweiten Multiplizierer (212), der einen zweiten Koeffizienten aufweist, dessen Ausgang mit dem zweiten Addierer (206) verbunden ist, und mit einem dritten Multiplizierer (214), der einen dritten Koeffizienten aufweist, dessen Ausgang mit einem dritten Addierer (216) verbunden ist, und
   - ein Ausgang des zweiten Addierers (206) einem vierten Addierer (218) zugeführt ist und
   - ein Ausgang des vierten Addierers (218) geteilt und mit einem zweiten Verzögerungsglied (220) und einem fünften Addierer (222) verbunden ist und
   - ein Ausgang des zweiten Verzögerungsglieds (220) geteilt und mit einem vierten Multiplizierer (224), der den ersten Koeffizienten aufweist, verbunden ist, dessen Ausgang verbunden ist mit dem vierten Addierer (218), mit einem fünften Multiplizierer (226), der den zweiten Koeffizienten aufweist, dessen Ausgang mit dem fünften Addierer (222) verbunden ist, und mit einem sechsten Multiplizierer (228), der einen vierten Koeffizienten aufweist, dessen Ausgang mit dem dritten Addierer (216) verbunden ist, und
   - ein Ausgang des dritten Addierers (216) einem dritten Verzögerungsglied (230) zugeführt ist,
   - ein Ausgang des dritten Verzögerungsglieds (230) geteilt und mit einem siebten Multiplizierer (232), der den ersten Koeffizienten aufweist, verbunden ist, dessen Ausgang verbunden ist mit dem dritten Addierer (216), mit einem achten Multiplizierer (234), der den dritten Koeffizienten aufweist, dessen Ausgang mit dem fünften Addierer (222) verbunden ist, und mit einem neunten Multiplizierer (236), der einen fünften Koeffizienten aufweist, dessen Ausgang mit dem vierten Addierer (218) verbunden ist, und
   - der vierte Koeffizient und der fünfte Koeffizient mit entgegengesetztem Vorzeichen einander gleich sind und

- eine Verstärkung mittels drei separater Multiplizierglieder (302, 304, 306) implementiert ist, die einen Quadratwurzelwert der Verstärkung aufweisen, wobei die separaten Multiplizierglieder jeweils vor dem dritten Multiplizierer (214), vor dem vierten Addierer (218) und vor dem ersten Addierer (204) angeordnet sind, wobei der Ausgang des fünften Addierers den realen Ausgang (240) des Filtersystems (201) bildet.

3. Filtersystem, das eine Kaskade von Filtern nach Anspruch 1 oder 2 umfasst.

4. Filtersystem einer ungeraden Ordnung, das eine Kaskade eines Filters erster Ordnung und ein Filtersystem nach Anspruch 1 oder 2 umfasst.

5. Filtersystem nach Anspruch 1, wobei die Übertragungsfunktion des Filtersystems wie folgt ist:

$$H_2(z) = K_2 \cdot \frac{z^{-1} - (\gamma + j\delta)}{z^{-1} - (\alpha + j\beta)} \cdot \frac{z^{-1} - (\gamma - j\delta)}{z^{-1} - (\alpha - j\beta)}$$

wobei K2 die Verstärkung ist, $\gamma$ gleich dem zweiten Koeffizienten mit entgegengesetztem Vorzeichen ist, $\delta$ gleich dem dritten Koeffizienten mit entgegengesetztem Vorzeichen ist, $\alpha$ der erste Koeffizient ist und $\beta$ der fünfte Koeffizient ist.

6. Filtersystem nach Anspruch 5, wobei die Werte der Nullstellen der Übertragungsfunktion des Filtersystems 1 oder -1 sind, sodass $\delta = \gamma = 0$.

7. Elektronische Einrichtung, die ein Filtersystem nach einem der vorherigen Ansprüche umfasst.

**Revendications**

1. Système (201) de filtre ayant une réponse impulsionnelle infinie ayant une entrée et une sortie réelles, dans lequel la fonction de transfert du système de filtre comprend au moins une paire de pôles et/ou de zéros, respectivement, conjugués complexes, et

- dans lequel l'entrée (202) réelle est envoyée à un premier additionneur (204),
- une sortie du premier additionneur (204) est subdivisée et connectée à un deuxième additionneur (206) et à une première temporisation (208), et
- une sortie de la première temporisation (208) est subdivisée et connectée à un premier multiplicateur (210) ayant un premier coefficient, dont la sortie est connectée au premier additionneur (204), à un deuxième multiplicateur (212) ayant un deuxième coefficient, dont la sortie est connectée au deuxième additionneur (206), et à un troisième multiplicateur (214) ayant un troisième coefficient, dont la sortie est connectée à un troisième additionneur (216),
et
- une sortie du deuxième additionneur (206) est envoyée à un quatrième additionneur (218), et
- une sortie du quatrième additionneur (218) est subdivisée et connectée à une deuxième temporisation (220) et à un cinquième additionneur (222), et
- une sortie de la deuxième temporisation (220) est subdivisée et connectée à un quatrième multiplicateur (224) ayant le premier coefficient, dont la sortie est connectée au quatrième additionneur (218), à un cinquième multiplicateur (226) ayant le deuxième coefficient, dont la sortie est connectée au cinquième additionneur (222) et à un sixième multiplicateur (228) ayant un quatrième coefficient, dont la sortie est connectée au troisième additionneur (216), et
- une sortie du troisième additionneur (216) est envoyée à une troisième temporisation (230), et
- une sortie de la troisième temporisation (230) est subdivisée et connectée à un septième multiplicateur (232) ayant le premier coefficient, dont la sortie est connectée au troisième additionneur (216), à un huitième multiplicateur (234) ayant le troisième coefficient, dont la sortie est connectée au cinquième additionneur (222), et à un neuvième multiplicateur (236) ayant un cinquième coefficient, dont la sortie est connectée au quatrième additionneur (218), et
- le quatrième coefficient et le cinquième coefficient sont égaux mais de signes opposés l'un à l'autre, et
- une sortie du cinquième additionneur (222) est envoyée à un dixième multiplicateur (238) ayant un gain (K, $K_2$), la sortie du dixième multiplicateur formant la sortie (240) réelle du système (201) de filtre.

**2.** Système (201) de filtre ayant une réponse impulsionnelle infinie ayant une entrée et une sortie réelles, dans lequel la fonction de transfert du système de filtre comprend au moins une paire de pôles et/ou de zéros, respectivement, conjugués complexes, et

- dans lequel l'entrée (202) réelle est envoyée à un premier additionneur (204),
- une sortie du premier additionneur (204) est subdivisée et connectée à un deuxième additionneur (206) et à une première temporisation (208), et
- une sortie de la première temporisation (208) est subdivisée et connectée à un premier multiplicateur (210) ayant un premier coefficient, dont la sortie est connectée au premier additionneur (204), à un deuxième multiplicateur (212) ayant un deuxième coefficient, dont la sortie est connectée au deuxième additionneur (206), et à un troisième multiplicateur (214) ayant un troisième coefficient, dont la sortie est connectée à un troisième additionneur (216),
et
- une sortie du deuxième additionneur (206) est envoyée à un quatrième additionneur (218), et
- une sortie du quatrième additionneur (218) est subdivisée et connectée à une deuxième temporisation (220) et à un cinquième additionneur (222), et
- une sortie de la deuxième temporisation (220) est subdivisée et connectée à un quatrième multiplicateur (224) ayant le premier coefficient, dont la sortie est connectée au quatrième additionneur (218), à un cinquième multiplicateur (226) ayant le deuxième coefficient, dont la sortie est connectée au cinquième additionneur (222) et à un sixième multiplicateur (228) ayant un quatrième coefficient, dont la sortie est connectée au troisième additionneur (216), et
- une sortie du troisième additionneur (216) est envoyée à une troisième temporisation (230), et
- une sortie de la troisième temporisation (230) est subdivisée et connectée à un septième multiplicateur (232) ayant le premier coefficient, dont la sortie est connectée au troisième additionneur (216), à un huitième multiplicateur (234) ayant le troisième coefficient, dont la sortie est connectée au cinquième additionneur (222), et à un neuvième multiplicateur (236) ayant un cinquième coefficient, dont la sortie est connectée au quatrième additionneur (218), et
- le quatrième coefficient et le cinquième coefficient sont égaux mais de signes opposés l'un à l'autre, et
- un gain mis en œuvre au moyen de trois éléments (302, 304, 306) multiplicateurs distincts ayant une valeur de racine carré dudit gain, les éléments multiplicateurs distincts étant placés, respectivement, avant le troisième multiplicateur (214), avant le quatrième additionneur (218) et avant le cinquième additionneur (204), la sortie du cinquième additionneur formant la sortie (240) réelle du système (201) de filtre.

**3.** Système de filtre comprenant une cascade de filtres suivant la revendication 1 ou 2.

**4.** Système de filtre d'un ordre impair comprenant une cascade d'un filtre du premier ordre et un système de filtre suivant la revendication 1 ou 2.

**5.** Système de filtre suivant la revendication 1, dans lequel la fonction de transfert du système de filtre est la suivante :

$$H_2(z) = K_2 \frac{z^{-1}-(\gamma+J\delta)}{z^{-1}-(\alpha+j\beta)} \frac{z^{-1}-(\gamma+J\delta)}{z^{-1}-(\alpha+j\beta)}$$

dans laquelle K2 est le gain, $\gamma$ est égal au deuxième coefficient de signe opposé, $\delta$ est égal au troisième coefficient de signe opposé, $\alpha$ est le premier coefficient et $\beta$ est le cinquième coefficient.

**6.** Système de filtre suivant la revendication 5, dans lequel les valeurs des zéros de la fonction de transfert du système de filtre sont 1 ou -1, de sorte que $\delta = \gamma = 0$.

**7.** Dispositif électronique comprenant un système de filtre suivant l'une quelconque des revendications précédentes.

## FIG 1

## FIG 2

## FIG 3

## FIG 4

FIG 5

FIG 6

# FIG 7

# FIG 8

FIG 9

FIG 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

*   US 7098731 B1

### Non-patent literature cited in the description

*   **P. GUILLAUME ; J. SCHOUKENS ; R. PIN-TELON.** Sensitivity of Roots to Errors in the Coefficient of Polynomials Obtained by Frequency-Domain Estimation Methods. *IEEE Trans. on Instr. and Meas,* December 1989, vol. 38, 1050-1056
*   Lecture 20: 2.161 Signal Processing: Continuous and Discrete. *MIT OpenCourseWar,* 2008, 20-1, 20-14
*   **MASKELL D L et al.** Analysis of even order IIR digital filters implemented as a cascade of first order complex allpass sections. *ISCAS,* 07 June 1988, 531-534
*   **D. SCHLICHTHÄRLE.** Digital Filters. Springer-Verlag, 2011, 420-437
*   **J. GOETTE.** Ftal Mse: Hardware Algorithms On Fixed-Point Filter Realizations. *MSE,* 10 October 2011, 1-103